# EUROPEAN PATENT SPECIFICATION

(11) **EP 3 127 168 B1**
(45) Date of publication and mention of the grant of the patent: **27.11.2019**
(21) Application number: 15714490.8
(22) Date of filing: 02.04.2015
(51) Int. Cl.: H01L 31/05, H01L 31/044

(54) **PHOTOVOLTAIC MODULE WITH BYPASS DIODES**
FOTOVOLTAISCHES MODUL MIT BYPASS-DIODEN
MODULE PHOTOVOLTAIQUE A DIODES EN PARALLELE

(30) Priority: 02.04.2014 NL 2012556
(43) Date of publication of application: 08.02.2017
(73) Proprietor: Nederlandse Organisatie voor toegepast- natuurwetenschappelijk Onderzoek TNO, 2595 DA 's-Gravenhage (NL)
(72) Inventor: BENDE, Evert Eugène, NL-1755 LE Petten (NL); JANSEN, Markus Johan, NL-1755 LE Petten (NL); VAN ROOSMALEN, Johannes Adrianus Maria, NL-1755 LE Petten (NL)
(74) Representative: Nederlandsch Octrooibureau
(86) International application number: PCT/EP2015/057302
(87) International publication number: WO 2015/150514

(56) References cited:
- WO-A1-89/05521
- WO-A1-2006/027225
- WO-A1-2010/135801
- WO-A2-2011/050367
- US-A- 4 481 378
- US-A1- 2009 025 778
- US-A1- 2014 060 610
- US-B1- 6 563 289

## Description

### Field of the invention

The present invention relates to a photovoltaic module comprising a back side conductive substrate and a plurality of PV-cells having back contacts and being arranged in an array on a top surface of the back side conductive substrate, wherein a circuit of series and/or parallel connected PV-cells is formed by connections between the back contacts and the back side conductive substrate.

### Prior art

International patent publication WO2006/027225 discloses a solar cell assembly and method for connecting a string of solar cells, including by-pass diodes having three contacts both on their upper and lower surface. This allows to contact a solar cell associated with the by-pass diode (in parallel), as well as provide a contact to a further solar cell (in series connection).

International patent publication WO2010/135801 discloses a photovoltaic module string arrangement having a shading protection implemented. Conductors and bypass diodes are provided on a perimeter margin of the photovoltaic module, and are connected to strings of cells.

International patent publication WO 2011/050367 discloses a PV module with a plurality of solar cells in the form of doped regions disposed on a single silicon substrate wherein backside contacts are provided. In an embodiment, subsets of the cells are provided connected in parallel, with one or more cells wired with its two connections in reverse of the other cells. These reverse cells then act as bypass diodes, and cannot contribute to energy generation (and lowering the effective surface of the PV module).

US patent publication US 2014/060610 discloses a PV module comprising back contact solar cells having an on-cell electronic component such as a bypass switch, which is also provided at the back side of the PV module. The publication discloses that the bypass switch may comprise e.g. a Schottky diode or pn-junction diode.

US patent publication US 6,563,289 discloses a solar cell arrangement comprising a bypass diode disposed on an oblique side of a solar cell, within an area bound by projections of two mutually orthogonal sides of the solar cell. The diode is electrically connected across the associated cell by a front interconnect and a back interconnect.

### Summary of the invention

The present invention seeks to provide a more efficient photovoltaic module, especially in the sense of shadow performance, use of the front surface of the photovoltaic module and in homogenous appearance of the photovoltaic module.

According to the present invention, a photovoltaic module according to the preamble defined above is provided, further comprising a plurality of by-pass diodes having back contacts in electrical contact with the circuit of series and/or parallel connected PV-cells wherein each by-pass diode is a wafer based diode and is connected in parallel with one or more of the plurality of photovoltaic cells and wherein the by-pass diodes are positioned on empty parts of the top surface of the back side conductive substrate, the empty parts being located between corners of adjacent ones of the plurality of PV-cells.

### Short description of drawings

The present invention will be discussed in more detail below, using a number of exemplary embodiments, with reference to the attached drawings, in which
Fig. 1 shows a view of a photovoltaic module according to an embodiment of the present invention;
Fig. 2 shows a circuit diagram of a type of circuit which is implemented in a further embodiment of the present invention;
Fig. 3 shows a circuit diagram of an alternative type of circuit which is implemented in a further embodiment of the present invention;
Fig. 4a and 4b show schematic views of a photovoltaic module according to even further embodiments of the present invention;
Fig. 5 shows a schematic view of a photovoltaic module using by-pass diodes according to yet a further embodiment of the present invention;
Fig. 6a and 6b show embodiments of the present invention applied in 6x10 module;
Fig. 7a and 7b show embodiments of the present invention applied in a landscape oriented 6x10 module;
Fig. 8a-8f shows cross sectional vies of by-pass diode variants as applied in the present invention embodiments;
Fig. 9 shows a graph of a dark current-voltage curve of a typical n-type PV-cell;
Fig. 10 shows a view of a photovoltaic module according to an alternative embodiment of the present invention.

### Detailed description of exemplary embodiments

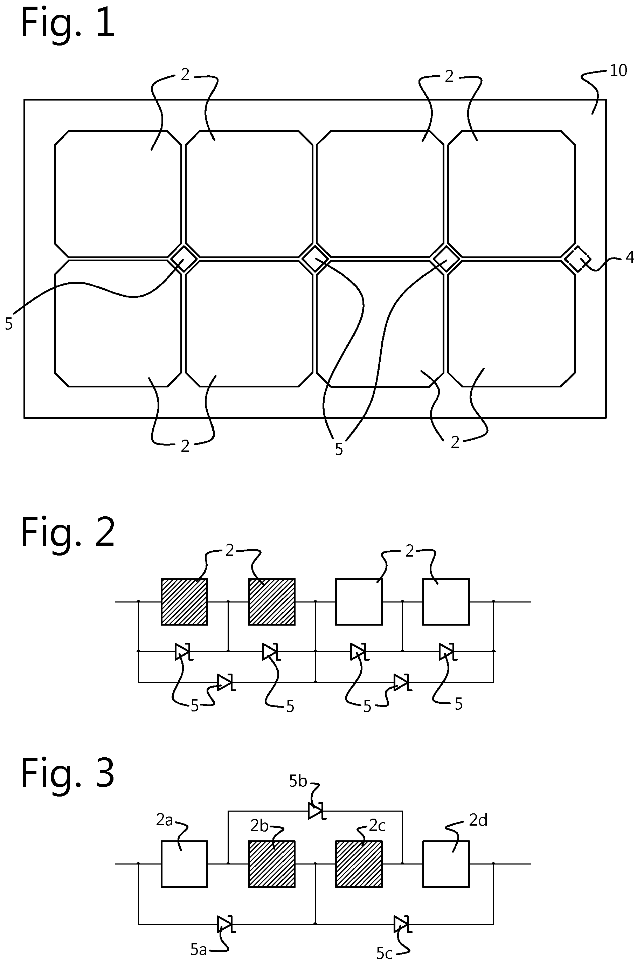

The present invention embodiments comprise an assembly of (semi-square) back-contact cells and back-contacted wafer-based by-pass diodes where the by-pass diodes are located in the diamond-shaped spaces in between semi-square solar cells, where cells and by-pass diodes are mounted on one or two conductive, patterned, foils where the conductive foils are isolated from each other. This is shown in the front view of an embodiment of a photovoltaic module according to the present invention as shown in Fig. 1. A plurality of PV-cells 2 are positioned on a back side conductive substrate 10. The PV-cells 2 have a semi-rectangular form, providing empty parts 4 in the middle of four PV-cells 2, as well as at the outer edges between two PV-cells. In these empty parts 4, by-pass diodes 5 are positioned. The semi-rectangular form is e.g. provided by cutting off edges of a cylinder shaped ingot with a diameter of 20 cm, and then slicing the ingot to obtain semi-square wafers of 15.6x15.6 cm². E.g. when using a Czochralski (Cz) monocrystal cylindrical ingot, slices can be cut off in a lengthwise direction. From these round slices, wafers are cut, having four straight edges with curved interconnecting corners, e.g. having a curvature with a radius of 10cm.

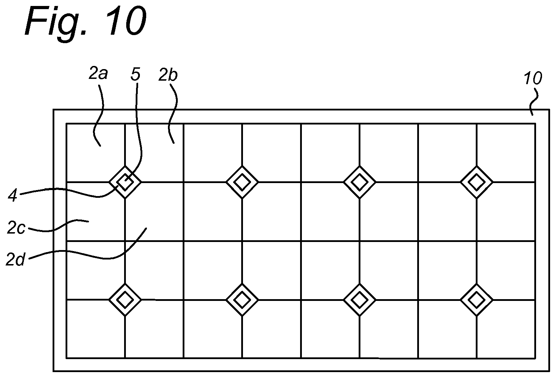

Alternatively, a semi-square form of the PV-cell 2 may be obtained by slicing such a semi-square form in two or four equal parts, thus obtaining PV-cells 2 with only one (or two) oblique corners, as shown in the embodiment of Fig. 10.

In alternative wording, a conductive foil based photovoltaic module is provided with semi-square (high efficiency) back-contacted solar cells, where the space in between the cells is used for wafer-based by-pass diodes. In this way, a module can be manufactured with a more homogeneous appearance and with enhanced shadow performance. All kind of tracks can be made in the conductive foil to create intricate electronic circuits, for the best possible response to shading.
In a first aspect, the present invention relates to a photovoltaic module comprising a back side conductive substrate 10 (in the form of a conductive layer or a (patterned) foil), a plurality of PV-cells 2 having back contacts and being arranged in an array on a top surface of the back side conductive substrate 10, wherein a circuit of series and/or parallel connected PV-cells 2 is formed by connections 8 between the back contacts and the back side conductive substrate 10, and a plurality of by-pass diodes 5 having back contacts 6a, 6b in electrical contact with the circuit of series and/or parallel connected PV-cells 2, wherein each by-pass diode 5 is a wafer based diode and is connected in parallel with one or more of the plurality of photovoltaic cells 2, and wherein the by-pass diodes 5 are positioned on empty parts 4 of the top surface of the back side conductive substrate 10, the empty parts 4 being located between corners of adjacent ones of the plurality of PV-cells 2.

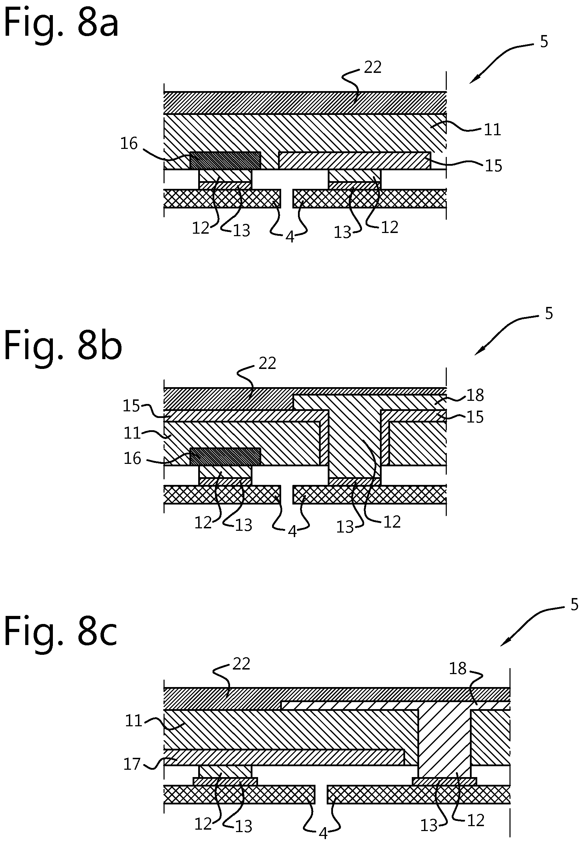

As mentioned, the plurality of by-pass diodes 5 may comprises wafer based diodes. These have a flat shape with a thickness which can be chosen to be similar in thickness to a PV-cell 2, or even slightly thicker (allowing more current to flow through the by-pass diode 5). E.g. the by-pass diodes 5 may be obtained from a multi-crystalline wafer, allowing a process much alike that of providing a PV-cell 2. Multiple bypass diodes 5 may be cut from a processed 15.6x15.6 cm (standard size) cell. The by-pass diode 5 may be obtained using similar techniques as used for obtaining back contact PV-cells 2, such as Metal Wrap Through (MWT), Emitter Wrap Through (EWT), Interdigitated Back Contact (IBC), or even Metal Wrap Around (MWA). Specific embodiments of by-pass diodes 5 usable in the present invention embodiments are discussed in more detail below, with reference to Fig. 8a-f. This standard and well known techniques may be very efficient, e.g. 8x8 wafer-based by-pass diodes 5 may be cut from a 15.6x15.6 cm² cell.

In a further embodiment, use is made of dummy wafer-based by-pass diodes 5, which can be positioned in the empty parts 4 enclosed by the rounded corners of the PV-cells 2 to give a homogeneous appearance of the photovoltaic module.

As mentioned above, and described with reference to the embodiment shown in Fig. 1, the plurality of by-pass diodes 5 are positioned near corners of adjacent ones of the plurality of PV-cells 2. These adjacent PV-cells 2 e.g. form an empty space 4 in the form of a square (diamond) of 2x2 cm, which is sufficient to accurately position a by-pass diode 5 e.g. having dimensions of 1.9x1.9 cm.

A by-pass diode 5 may be present for each of the plurality of PV-cells 2, allowing a very efficient protection functionality.

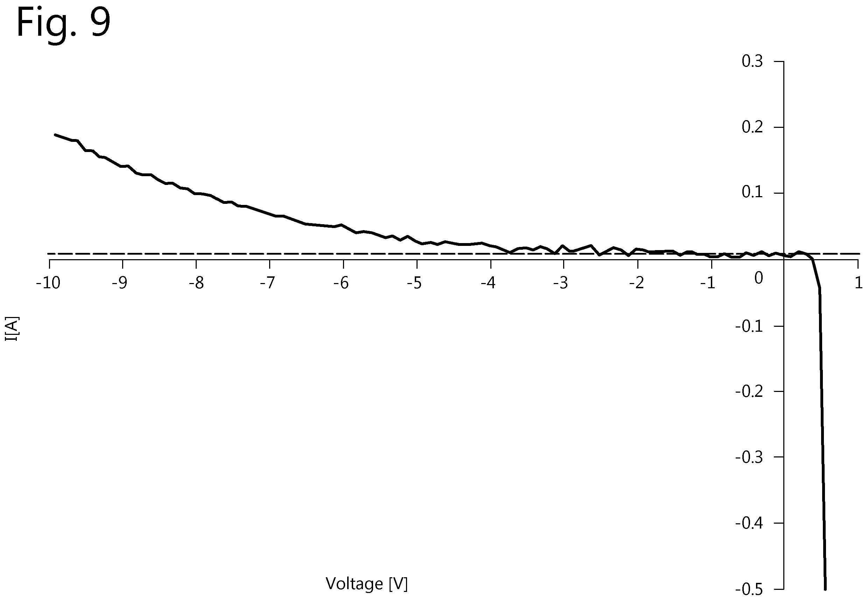

Fig. 9 shows a typical dark IV-curve of an n-type solar cell 2. The broken line indicates the 0.1%-value of the module's nominal short-circuit current under illumination at Standard Test Conditions (STC). This graph shows that solar cells with the IV characteristics of the solid curve can be used up to -4V in order not to exceed the 0.1% value of the nominal current. This implies that if this solar cell is made opaque and used as a by-pass diode 5 and if it is connected in parallel over siz series connected solar cells 2 each typically having an open-circuit voltage of 0.65V, the leakage current of the by-pass diode 5 stays below 0.1% of the module's short circuit current, which is acceptable. At the same time under shading conditions a positive bias over the by-pass diode 5 leads to an exponential current increase and 9A can be easily accomodated at voltages between +0.5 and +1V. The graph also shows that by-passing much more solar cells 2 all adding up to -10V exceeds more than 1%-leakage under nominal (unshaded) conditions.

In conventional modules a by-pass diode 5 is typically connected in parallel with twenty PV-cells 2. This implies that under unshaded conditions the by-pass diode 5 typically is subject to a negative bias of typically 20 x -0.5 = -10V. This puts stringent requirements to the by-pass diodes 5 IV characteristics. In forward bias (in case of shading) the by-pass diode 5 should be able to conduct 9A at voltages typically lying between +0.5V and +1V. At the same time, in unshaded conditions the by-pass diodes 5 should not exhibit a significant leakage current at -10V. In that case the leakage current should typically be less than 0.1% of the PV module's short-circuit current of typically 9A. In conventional modules rather expensive by-pass diodes 5 are needed that fulfill this requirement. However, many solar cells 2 in the dark yield currents higher than this at the mentioned -10V and are therefore not suitable for by-passing twenty cells. However, the present invention embodiments enable circuits where every PV-cells 2 is by-passed by a wafer-based by-pass diode 5 and in these circumstance the negative bias, under unshaded conditions, is much smaller and the leakage current is sufficiently low. So, by applying more by-pass diodes 5 per solar cell 2 less stringent requirements for the by-pass diodes 5 are needed and one can resort to wafer-based solar cells that are made opaque and therefore can act as by-pass diodes 5. This implies that one can prevent the use of expensive, high-quality, by-pass diodes that are used in conventional modules, usually located in the by-pass diode box mounted on the rear side of the module. It also implies that one can manufacture wafer-based by-pass diodes by cutting it from a 'mother' solar cell. This results in by-pass diodes 5 with bare edges, adversely affected by the cutting process (e.g. using a laser). These bare, possibly damaged, edges results in enhanced recombination of carriers and therefore in higher I0 values, where we have the approximate equation I=I0^{∗}exp(V/n/vth), where I is the current through the by-pass diode 5 as a function of its voltage V and where n is the ideality factor, typically between 1 and 2 and where vth is the thermal voltage (vth=k_B ^{∗} T/ q), i.e. approximately 0.0257 V at room temperature. Higher I0 values imply higher leakage current at negative bias (unshaded module conditions) and also higher currents at (shaded conditions) forward bias. More by-pass diodes 5 per cell 2 allow higher I0 values and therefore enables wafer-based by-pass diodes 5 cut from 'mother' cells with bare edges. By applying an edge passivation (e.g. coatings of Al₂O₃, SiNx, SiO₂) on the edges the I0 values can be further reduced and the wafer-based by-pass diodes 5 can be used for circuits where up to, typically, twenty four cells 2 can be connected in parallel. A trade-off exists between quality of the by-pass diode 5 (low Io) and the cost to manufacture them. The current invention embodiments allow many by-pass diode circuit solutions amongst which one can determine the most cost-effective solution for a preferred shading behavior.

By-pass diodes 5 and PV-cells 2 can be mounted on the back foil (back side conductive substrate 10) with the same pick-and-place tool in the manufacturing process. This allows easy manufacturing of the module and prevents issues with stress build up in module. It prevents mounting of a by-pass diode box on the rear side of the module, giving more flexibility in applications (flatter panels). E.g. a conductive adhesive may be used to position and attach the PV-cells 2, as well as the by-pass diodes 5 to the back side conductive substrate 10.

The invention results in a shade tolerant module both for small shade areas and bigger shade areas. Applications are e.g. advantageous in shade-rich environments. More dense positioning (shorter intra module distances) in a field or on a flat roof, will cause self-shading. These modules allow these dense packaging since they are more tolerant to shade. In the winter at low sun inclinations more self shade will occur, but the modules are more tolerant to these shades, whereas in the summer more power can be harvested from a flat roof per unit of area due to the closer packing.

As mentioned, the by-pass diodes 5 of the present invention embodiments can be mounted to the conductive foil (formed by, or part of the back side conductive substrate 10) in the same way as the PV-cells 2 are mounted. This is technically much easier than mounting different types of devices, such as solar cells and SMDs. The same or similar pick-and-place robot can be used in the same machine. The same contacting process (e.g. stencil printing conductive adhesive on a patterned copper foil) can be utilized.

Conventional modules have e.g. three strings of PV-cells connected in series, where each string has a by-pass diode. These modules have non-optimal shade behavior. Shading one cell will take down one entire string, i.e. one third of the photovoltaic panel. Horizontal shading of, say, 6 cells in a row distributed over three strings will take down the entire module. Moreover, the area that the string occupies is elongated which makes the module vulnerable to shades that have its elongation perpendicular to the elongated string-area.

Moreover, the bypass diodes are adding to the costs of the module. In addition, the by-pass diodes need to be accommodated in the by-pass diode box. This box is placed on the rear-side of the module which brings about limitations of module applications, e.g. flat, in-roof mounting is hampered by the size of the by-pass diode box, in particular for frameless modules.

Incorporating more than the conventional three by-pass diodes is an alternative solution. However, the difficulty here is that it is increasingly difficult to accommodate all these by-pass diodes in a by-pass diode box. This would require a vast amount of conductive leads (bussing) towards the by-pass diode box. Moreover the number of by-pass diodes is limited due to the topology of the bussing (cross-overs of bussing and tabbing is cumbersome and would require bus-tab isolation and bigger inter-cell spacings). More bypass diodes and more (complicated) tabbing and bussing is also a cost concern.

Alternatively, by-pass diodes can be laminated together with the photovoltaic cells. However due to the size of a conventional by-pass diode, that is able to carry 9A, this brings about lamination difficulties (stress/tension). Moreover, by-pass diodes will add to the cost of the PV-panel (see e.g. the disclosure of WO2010/135801 discussed above).

The photovoltaic module embodiments of the present invention aims to be shade tolerant both for small and bigger shade areas. For small shade areas, typically up to 36 cm², i.e. 15% opaqueness on a 15.6 cm high shunt resistance semi-square cell 2, it acts as a conventional module whereas for bigger shade areas the high number of by-pass diodes 5 takes care of good shade behavior by by-passing only small groups of shaded PV-cells 2 rather than big groups of shaded cells (e.g. twenty cell strings) in a conventional module.

It is noted that the empty part 4 or empty space between PV-cells 2 can have any form, depending on the outer circumferential shape of the PV-cell 2 (or sub-module of a plurality of smaller PV-cells), and may provide sufficient space for one, two (semi-diamond shaped) by-pass diodes 5, or even more. In an exemplary embodiment, the plurality of PV-cells 2 each have a semi-square form and by-pass diodes 5 are positioned in an open space 4 between the corners of adjacent PV-cells 2. In an alternative exemplary embodiment, the by-pass diodes have a triangular form. Two of such by-pass diodes 5 can then be positioned in a diamond shaped space 4 in between four adjacent PV-cells 2, or a single triangular shaped by-pass diode 5 fits into a space 4 between two adjacent PV-cells 2 at an edge of the photovoltaic module.

In an alternative embodiment, which is shown schematically in Fig. 10, the plurality of PV-cells 2 are rectangular with at least one oblique corner, e.g. made by cutting a 'normal' wafer based cell in two or four. The plurality of PV-cells 2 are arranged in groups of two or four with the respective at least one oblique corners facing each other and forming the empty parts 4 of the top surface of the back side conductive substrate 10 for the by-pass diodes 5. As a result it is possible to provide a PV module where on the edges only straight rectangular shaped sides of the PV-cells 2 are present. In the embodiment shown all by-pass diodes 5 may be provided in the open spaces 4 provided near to the adjacent oblique corners of four PV-cells 2.

The present invention embodiments make use of the semi-square nature of wafers that are used in some module technologies to place the by-pass diodes 5 in the spaces 4 between the PV-cells 2 or PV sub-modules, where anyhow it is very easy to let the conductive copper foil (of the back side conductive substrate 10) reach these space 4. In other concepts, square wafers (PV-cells 2) are used. In this case it might still be beneficial to integrate wafer-based by-pass diodes 5 in the electrical circuitry, to allow more by-pass diodes 5 than are generally used in a junction box. For this reason parts of the square wafers 2 can even be cut out (e.g. corners) to allow integration of wafer-based by-pass diodes 5 in the circuitry, or they are placed in additional spaces that are realized between the PV-cells 2 or at the edges of the module. In this case, the shape might be preferably rectangular (e.g. with the length of a full wafer) rather than square. The size of the wafer-based bypass diode 5 (and therefore the size of the cutout) can e.g. be matched to the current that they need to be able to carry. To allow for the optimal current through the by-pass diode 5, the wafers that are used to process by-pass diodes 5 could be made thicker than standard wafers, as long as the thickness is tolerated in the laminate (encapsulant thickness) of the photovoltaic module.

Providing the by-pass diodes 5 as wafer based diodes this allows to have a sufficiently high current rating of the plurality of by-pass diodes 5, e.g. at least 6A, e.g. 9A. With a 2x2cm wafer diode 5, this would result in a current density of 2.12A/cm², or 4.5W dissipated power (when active in by-pass mode). Of course, if different circuits are used, using more or less by-pass diodes 5 per PV-cell 2, the requirements on current rating may be different. When smaller sized PV-cells 2 (or rather sub-modules 2) are used, the current rating of the associated by-pass diodes 5 may be lower, e.g. at least 2.25A in the case of a quarter sized sub-module 2, or at least 4.5A in the case of half-size sub-module 2.

In further alternative embodiments, it would also be possible to provide one, multiple or all of the plurality of by-pass diodes 5 in other empty parts 4 available in the photovoltaic module, e.g. at the outer edges thereof. When positioned near an edge of an associated PV-cell 2, e.g. having an elongate shape, by-pass diodes 5 may be efficiently positioned, even possible having better I-V characteristic for that specific part of the photovoltaic module.

In the embodiments described above, the term PV-cell 2 is used. However, this term is intended to also include sub-modules or groups of (smaller sized) PV-cells. E.g. in an embodiment the semi-square 'mother' PV-cell 2 of a standard size (5"x5" or 6"x6") is cut into m x n equal-area solar cells. This will reduce the current and to increase the voltage, and as an effect a lower current means less dissipation in the associated by-pass diode 5 as well.

In a specific embodiment, the plurality of PV-cells 2 are made from wafers of a semi-conductor material, e.g. mono-crystalline Czochralski (Cz) type material. This material is created by cutting off four edges from a cylindrical silicon rod, resulting in four straight sides and four rounded corners, where the diameter typically is 20 cm and the edge-to-edge distance typically is 15.6 cm. When combined this results in an open diamond shaped surface part between four adjacent PV-cells 2. In a further exemplary embodiment, semi-square photovoltaic cells 2 are used with a side-to-side distance of 15.6 cm and a corner-to-corner distance of 20 cm, including square by-pass diodes 5 of 2.06 cm x 2.06 cm positioned in the spaces 4 between the photovoltaic cells 2.

In an alternative embodiment, each wafer obtained would be divided in four equal parts, resulting in smaller PV-cells 2 each having only one oblique corner, as shown in the embodiment of Fig. 10. It would then be possible to make a PV-module having 60 strings with four PV-cells 2 per string (thus 240 PV-cells 2 per module, cut from 60 wafers. The operational parameters would be :Vₘₚₚ=132 V; Iₘₚ=2.1 A; P_{loss_foil}∼ 0.85W (Conventional foil-module: ∼3.4 W) and a maximum dissipation in each cell of P_{md}=0.6 V x 3 x 2.1 = 3.8 W only (Conventional module: P_{md}=90W (20 cells per string, 9A). The 60 by-pass diodes 5 in such a module would dissipate 0.04W, and when in conduction a single bypass diode would dissipate only 1.7 W. A slightly lower cost than conventional module seems possible, plus an additional benefit that a much lower dissipation would occur in shaded cells thanks to short strings and low current. The loss of the by-pass diodes 5 under nominal condition would be negligible (Dissipation in by-pass diodes 5 under reverse condition only 1.7W (i.e. ∼0.5 W/cm2)).

A careful choice of cutting lines in a 20 cm diameter wafer could even improve efficient use of the semiconductor ingot material. In the standard much used form, where the PV-cells would take a 15.6cm as longest dimension, 76% if the wafer material is used.

When taking a slightly larger basic form of the PV-cell 2 (16.8 cm as largest dimension, when split in four resulting in a largest dimension of the PV-cell 2 of 8.4cm), sufficient wafer material remains for cutting four by-pass diodes 5 (e.g. triangular shaped) with a sufficient dimension to provide high enough capacities to be utilized in the present invention embodiments. This would result in 86% of the wafer surface to be utilized, the by-pass diodes 5 then being obtained with no additional semiconductor material costs.

When assembling the PV module, the (smaller) PV-cells 2 can be individually positioned on the back side conductive substrate 10 (possibly using rotation for the proper positioning), or four smaller PV-cells 2 can be positioned simultaneously (as a regular larger sized PV-cell 2) with only the PV-cells 2 at the edges of the PV-module being positioned individually.

In further embodiments, the number of by-pass diodes 5 in relation to the number of PV-cells 2 may vary, depending on the type of circuit being formed in the photovoltaic module. The circuit may comprise serial groups of PV-cells 2 and by-pass diodes 5, staggered groups and/or multilevel groups.

An example of a multilevel circuit of PV-cells 2 and by-pass diodes 5 is shown in Fig. 2. Each PV-cell 2 is provided with a parallel connected by-pass diode 5, and two groups of each two PV-cells 2 are connected in parallel to two additional by-pass diodes 5 (in total 6 by-pass diodes for 4 PV-cells 2. Suitable connecting tracks 8 can be made in the back side conductive substrate 10 (conductive foil). A solar cell or PV-cell 2 may belong to a string, i.e. one or more solar cells 2 connected in series, and the series connected string has a by-pass diode 5. Multiple strings connected in series may be by-passed with a higher-level bypass diode 5.

Alternatively, tracks 8 can be made where a solar cell 2 and a by-pass diode 5 are connected in parallel, recursively. Here a solar cell 2 and a bypass diode 5 are connected in parallel, and this parallel connection is in its turn connected in parallel with again a solar cell 2 and a bypass diode 5. This newly formed circuit is then again connected in parallel with a solar cell 2 and a bypass diode 5. This can be repeated n times.

In Fig. 3 a circuit of PV-cells 2 and by-pass diodes 5 is shown in the form of a staggered or crosswise circuit. Here, a solar cell 2 can be by-passed by different bypass diodes 5. A number of solar cells 2 can be divided in three subsets 2a, 2b; 2b, 2c; 2c, 2d, each subset is a series connection of at least one solar cell 2 and the subsets are series connected with each other. The first subset 2a, 2b is connected in parallel with a first by-pass diode 5a, the second subset 2b, 2c with by-pass diode 5b and the third subset 2c, 2d with by-pass diode 5c.

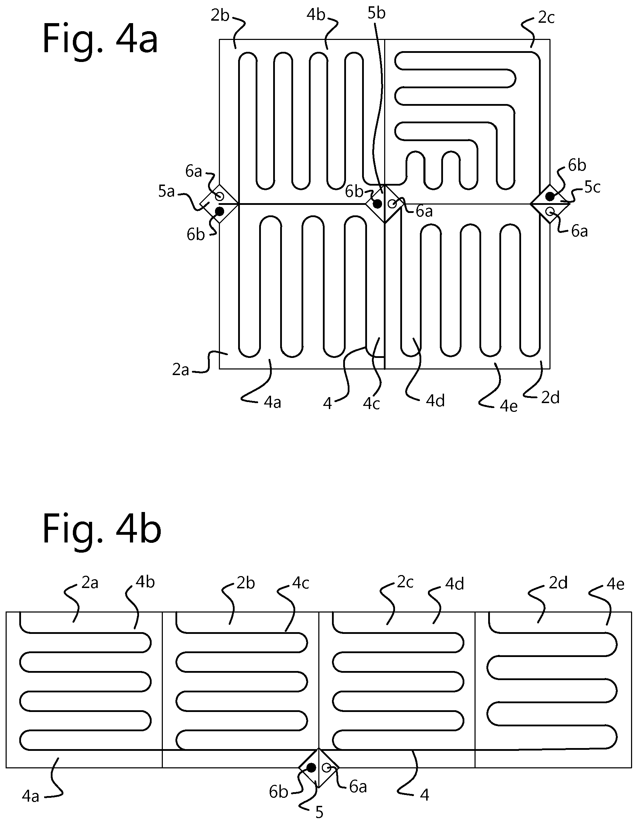

Such a staggered circuit is also used in the embodiment shown in Fig. 4. This photovoltaic module comprises four sub-modules 2a-2d, and in the empty parts left over by the four sub-modules 2a-2d, three bypass diodes 5a-c are provided. The back side conductive foil is divided in five interconnecting surfaces, by e.g. making scribe lines 4 in the back side conductive substrate 10 (areas 4a-4e are formed, e.g. connecting positive and negative terminals of mini cells in each of the sub-modules 2a-2d). The areas 4a-4e are also used to provide the connections to the by-pass diodes 5a-5c.

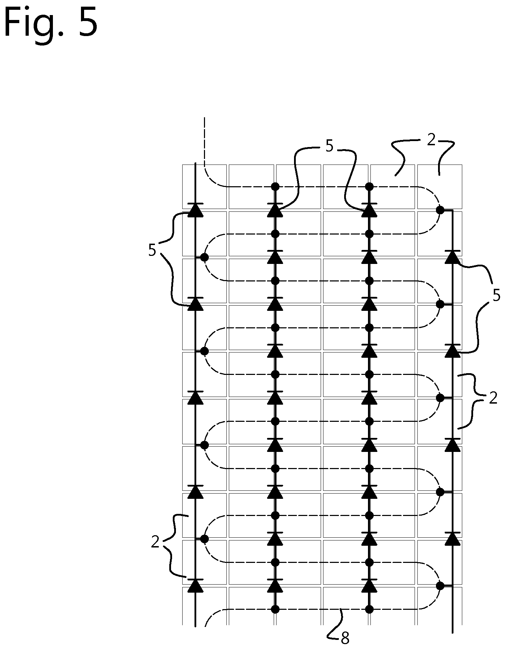

In Fig. 5 an embodiment is shown of a 6 cell wide array of PV-cells 2, with connections 8 indicated as a meandering line. By-pass diodes 5 are provided in the middle of four-cell groups of PV-cells (i.e. at the cross lines of the grid shown in Fig. 5), and connections are made with the meandering connection 8, in this case in parallel to strings of 4, 8 and 12 PV-cells. Some of the by-pass diodes 5 are provided at the edge of the grid, e.g. in the corner between two adjacent cells 2.

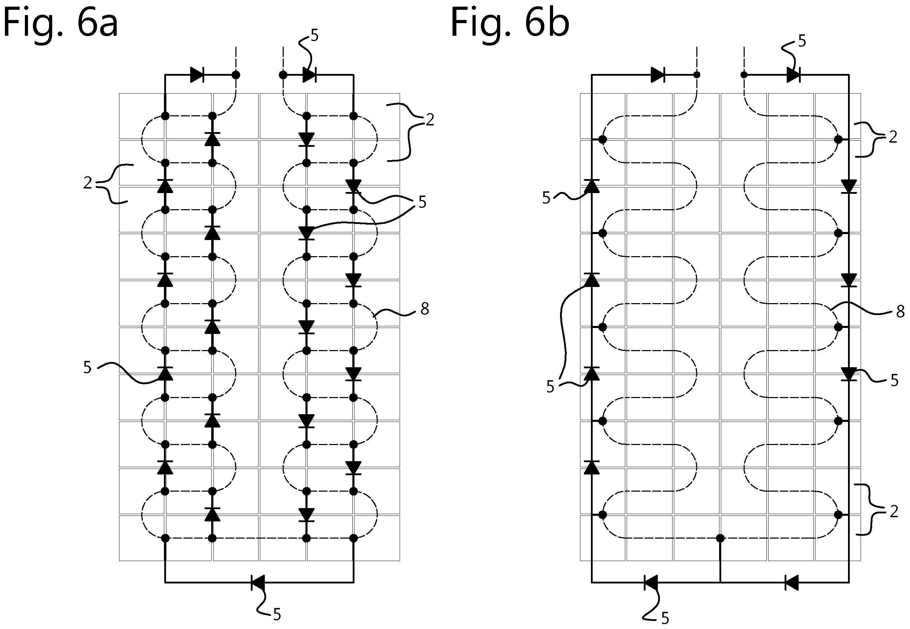

Fig. 6a and 6b show a 6x10 array of PV-cells 2 forming a photovoltaic module of a regular type. A positive (+) and negative (-) terminal of the photovoltaic module are indicated, as well as a meandering connection 8 connecting all of the 60 PV-cells 2. The by-pass diodes 5 are again positioned locally at a corner of four PV-cells 2 or at the edges of two PV-cells 2. Fig. 6a show a possible implementation of a staggered circuit using the by-pass diodes 5. In Fig. 6b, each string of three or six PV-cells 2 are connected in parallel to a by-pass diode 5.

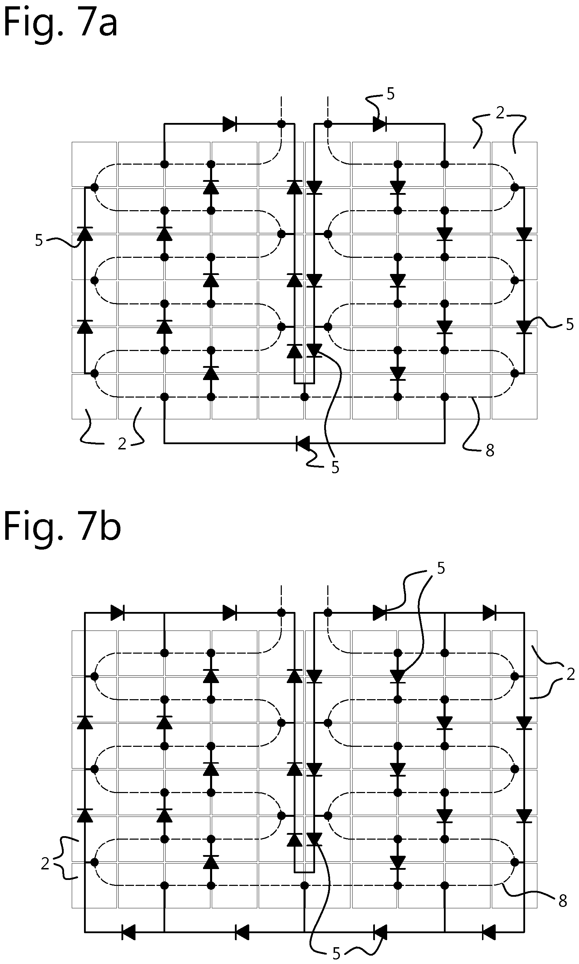

Fig. 7a and 7b show yet a further embodiment, again for a 'standard' size 6x10 photovoltaic module (now in landscape orientation). Again, the by-pass diodes 5 are located at corners or edges local to the string of PV-cells 2 it protects. Both implementations use a five cell string of PV-cells as basis, and a staggered circuit.

It is noted that the back side conductive substrate 10 is primarily used for providing contacts between PV-cells 2 and other components of the photovoltaic module. It may however also comprise material implementing a structural function, e.g. using a light-weight panel. The back side conductive substrate 10 in a further embodiment comprises one or more conductive sheets. These multiple sheets may be advantageous by allowing easier formation of interconnecting circuits as desired. The one or more conductive sheets are isolated from each other, and possibly provided with openings or apertures allowing to interconnect the conductive sheets where desired, to define an even more complex circuit of PV-cells 2.

In general the plurality of by-pass diodes 5 as used in the present invention implementations comprise a front surface 22 with a texture and color similar to a front surface of the PV-cells 2. E.g. a texture and SiNx top layer just like regular solar cells may be provided, to give the by-pass diode 5 the same appearance as the PV-cell 2. This provides for a similar appearance of the majority of components of the photovoltaic module visible during actual operation thereof, improving the aesthetic aspects and thus ease of integrating the photovoltaic module in buildings, etc.

Several types of (wafer based) by-pass diodes may be used, examples of which are shown in the cross sectional views of Fig. 8a-f. It is noted that like parts or components of the by-pass diode 5 embodiments are indicated with the same reference numeral in Fig. 8a-f. All the by-pass diodes 5 are provided with an opaque front surface 22, in order to prevent a possible photo-current generation. It is noted that also the rear surface of the by-pass diode 5 may be provided with an opaque layer for the same reason.

Fig. 8a shows a back-junction back-contact by-pass diode with an opaque (paint of any color, non-transparent tape, TiO₂-coating for enhanced scattering) front surface 22. The cross sectional view shows the conductive foil parts 4 (for making the circuit), which form part of the back side conductive substrate 10. The actual by-pass diode 5 comprises the (metal) contact pads 12 (connected to the conductive foil using e.g. a conductive adhesive 13), and the p-doted material 11. A back surface field 16 is formed, as well as an emitter 15.

Fig. 8b shows a front junction back contact type of by-pass diode 5. The emitter 15 is now provided at the front, and via a metal wrap through connection or via metallization 18, the electrical connection to the back side of the by-pass diode 5 is made.

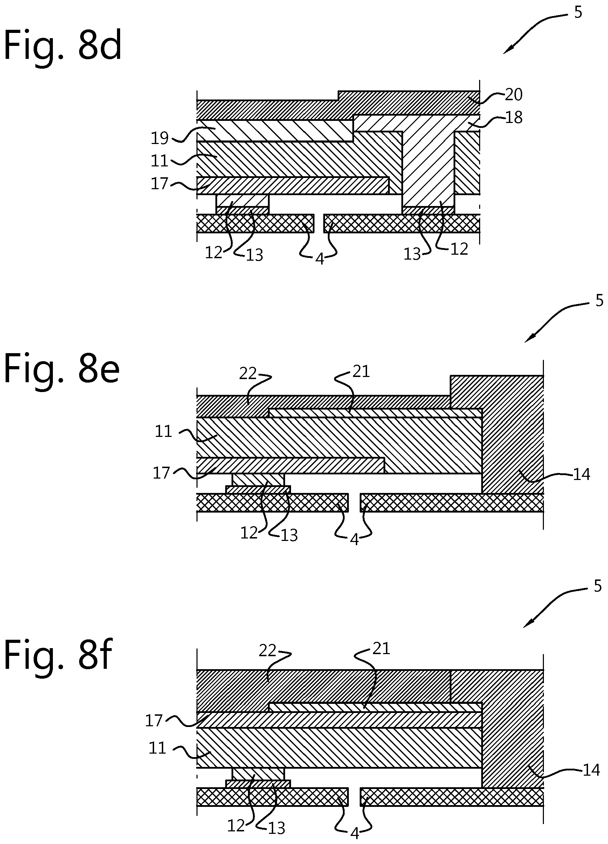

Fig. 8c shows a variant as a back junction metal wrap through diode 5. One contact is to the n+ region 17, while the other contact is made using a silver layer 18 in combination with a silver wrap through connection. Fig. 8d shows a variant, where the front side surface is a full-area Aluminium metallization (opaque) 20. The via metallization 18 makes contact with the Al metallization 20, which in turn contacts the p doted region 11 via a p+ doted region 19.

Fig. 8e and 8f show metal wrap around implementations of a by-pass diode 5, where the front to back contact is provided by a contacting medium 14, such as solder or a conductive adhesive. The contacting medium 14 contacts an electrode layer 21 at the front side of the by-pass diode 5, which in turn is in contact with the p region 11. In the embodiment of Fig. 8f, the p region 11 and n+ region 17 are reversed from back to front (junction at front side versus junction at rear side).

As a further alternative embodiment to the opaque layer 22, an embodiment is provided where the by-pass diodes 5 have a structured top surface 22 (e.g. white paint with Lambertian reflection, TiO₂ spheres coating or a grating structure) so that light is reflected or scattered by this layer 22 so that a big part of the light stays inside the photovoltaic module via internal reflectance (e.g. on a glass-air interface). In other words, the plurality of by-pass diodes 5 comprise a light diversion top layer arranged for directing light impinging on the front surface of the by-pass diode 5 towards the adjacent PV-cells 2.

The present invention embodiments have been described above with reference to a number of exemplary embodiments as shown in the drawings. Modifications and alternative implementations of some parts or elements are possible, and are included in the scope of protection as defined in the appended claims.

## Claims

1. Photovoltaic module comprising
a back side conductive substrate (10),
a plurality of photovoltaic (PV) cells (2) having back contacts and being arranged in an array on a top surface of the back side conductive substrate (10), wherein a circuit of series and/or parallel connected PV-cells (2) is formed by connections (8) between the back contacts and the back side conductive substrate (10), and
a plurality of by-pass diodes (5) having back contacts (6a, 6b) in electrical contact with the circuit of series and/or parallel connected PV-cells (2), wherein each by-pass diode (5) is a wafer based diode and is connected in parallel with one or more photovoltaic cells of the plurality of photovoltaic cells (2), **characterised in that** the by-pass diodes (5) are positioned on empty parts (4) of the top surface of the back side conductive substrate (10), the empty parts (4) being located between corners of adjacent ones of the plurality of PV-cells (2).

2. Photovoltaic module according to claim 1, wherein the wafer based diodes are obtained from a multi-crystalline wafer.

3. Photovoltaic module according to claim 1 or 2, wherein each by-pass diode of the plurality of by-pass diodes (5) comprises a metal wrap through, emitter wrap through or interdigitated back contact configuration.

4. Photovoltaic module according to any one of claims 1-3, wherein each PV-cell of the plurality of PV-cells (2) has a rectangular form with at least one oblique corner.

5. Photovoltaic module according to any one of claims 1-3, wherein each PV-cell of the plurality of PV-cells (2) is rectangular with at least one oblique corner, and the plurality of PV-cells (2) are arranged in groups of two or four with the respective at least one oblique corners facing each other and forming the empty parts (4) of the top surface of the back side conductive substrate (10) for the by-pass diodes (5).

6. Photovoltaic module according to any one of claims 1-5, wherein the by-pass diodes (5) have a triangular form.

7. Photovoltaic module according to any one of claims 1-6, wherein a by-pass diode (5) is present for each PV-cell of the plurality of PV-cells (2).

8. Photovoltaic module according to any one of claims 1-7, wherein each by-pass diode of the plurality of by-pass diodes (5) is positioned at an edge of an associated PV-cell (2).

9. Photovoltaic module according to any one of claims 1-8, wherein the PV-cell (2) comprises a sub-module with a plurality of smaller sized PV-cells (2).

10. Photovoltaic module according to any one of claims 1-9, wherein each PV-cell of the plurality of PV-cells (2) is made from wafers of a semiconductor material, e.g. of mono-crystalline Cz type material.

11. Photovoltaic module according to any one of claims 1-10, wherein each by-pass diode of the plurality of by-pass diodes (5) comprises a front surface (22) with a texture and color similar to a front surface of the PV-cells (2).

12. Photovoltaic module according to any one of claims 1-11, wherein each by-pass diode of the plurality of by-pass diodes (5) comprises an opaque front surface (22).

13. Photovoltaic module according to any one of claims 1-12, wherein each by-pass diode of the plurality of by-pass diodes (5) comprises a light diversion top layer arranged for directing light impinging on the front surface (22) of the by-pass diode (5) towards the adjacent PV-cells (2).

14. Photovoltaic module according to any one of claims 1-13, wherein the back side conductive substrate (10) comprises one or more conductive sheets.

15. Photovoltaic module according to any one of claims 1-14, wherein the circuit comprises serial groups of PV-cells (2) and by-pass diodes (5), staggered groups of PV-cells (2) and by-pass diodes (5), and/or multilevel groups of PV-cells (2) and by-pass diodes (5).

## Patentansprüche

1. Photovoltaikmodul, umfassend
ein rückseitiges leitfähiges Substrat (10),
eine Vielzahl von Photovoltaik- (PV) Zellen (2), die Rückseitenkontakte aufweisen und in einer Anordnung auf einer oberen Oberfläche des rückseitigen leitfähigen Substrats (10) angeordnet sind,
wobei ein Schaltkreis aus in Reihe und/oder parallel geschalteten PV-Zellen (2) durch Verbindungen (8) zwischen den Rückseitenkontakten und dem rückseitigen leitfähigen Substrat (10) gebildet ist, und
eine Vielzahl von Bypass-Dioden (5), die Rückseitenkontakte (6a, 6b) in elektrischem Kontakt mit dem Schaltkreis aus in Reihe und/oder parallel geschalteten PV-Zellen (2) aufweisen, wobei jede Bypass-Diode (5) eine Waferbasierte Diode ist und mit einer oder mehreren Photovoltaikzellen der Vielzahl von Photovoltaikzellen (2) parallel geschaltet ist,
**dadurch gekennzeichnet, dass**
die Bypass-Dioden (5) auf leeren Teilen (4) der oberen Oberfläche des rückseitigen leitfähigen Substrats (10) positioniert sind, wobei sich die leeren Teile (4) zwischen den Ecken von angrenzenden Exemplaren der Vielzahl von PV-Zellen (2) befinden.

2. Photovoltaikmodul nach Anspruch 1, wobei die Wafer-basierten Dioden aus einem multikristallinen Wafer erzielt werden.

3. Photovoltaikmodul nach Anspruch 1 oder 2, wobei jede Bypass-Diode der Vielzahl von Bypass-Dioden (5) eine Metal-Wrap-Through-, Emitter-Wrap-Through- oder ineinandergreifende Rückseitenkontakt-Konfiguration umfasst.

4. Photovoltaikmodul nach einem der Ansprüche 1 bis 3, wobei jede PV-Zelle der Vielzahl von PV-Zellen (2) eine rechteckige Form mit mindestens einer schrägen Ecke aufweist.

5. Photovoltaikmodul nach einem der Ansprüche 1 bis 3, wobei jede PV-Zelle der Vielzahl von PV-Zellen (2) rechteckig mit mindestens einer schrägen Ecke ist, und die Vielzahl von PV-Zellen (2) in Gruppen von zwei oder vier angeordnet ist, wobei sich die jeweiligen, mindestens eine, schrägen Ecken einander gegenüberstehen und die leeren Teile (4) der oberen Oberfläche des rückseitigen leitfähigen Substrats (10) für die Bypass-Dioden (5) bilden.

6. Photovoltaikmodul nach einem der Ansprüche 1 bis 5, wobei die Bypass-Dioden (5) eine dreieckige Form aufweisen.

7. Photovoltaikmodul nach einem der Ansprüche 1 bis 6, wobei eine Bypass-Diode (5) für jede PV-Zelle der Vielzahl von PV-Zellen (2) vorhanden ist.

8. Photovoltaikmodul nach einem der Ansprüche 1 bis 7, wobei jede Bypass-Diode der Vielzahl von Bypass-Dioden (5) an einem Rand einer dazugehörigen PV-Zelle (2) positioniert ist.

9. Photovoltaikmodul nach einem der Ansprüche 1 bis 8, wobei die PV-Zelle (2) ein Untermodul mit einer Vielzahl von kleineren PV-Zellen (2) umfasst.

10. Photovoltaikmodul nach einem der Ansprüche 1 bis 9, wobei jede PV-Zelle der Vielzahl von PV-Zellen (2) aus Wafern aus einem Halbleitermaterial, z.B. aus einem monokristallinen Cz-Material, ausgebildet ist.

11. Photovoltaikmodul nach einem der Ansprüche 1 bis 10, wobei jede Bypass-Diode der Vielzahl von Bypass-Dioden (5) eine vordere Oberfläche (22) mit einer Textur und Farbe, die ähnlich wie eine vordere Oberfläche der PV-Zellen (2) ist, umfasst.

12. Photovoltaikmodul nach einem der Ansprüche 1 bis 11, wobei jede Bypass-Diode der Vielzahl von Bypass-Dioden (5) eine undurchsichtige vordere Oberfläche (22) umfasst.

13. Photovoltaikmodul nach einem der Ansprüche 1 bis 12, wobei jede Bypass-Diode der Vielzahl von Bypass-Dioden (5) eine lichtablenkende obere Schicht umfasst, die angeordnet ist, um Licht, das auf die vordere Oberfläche (22) der Bypass-Diode (5) auftrifft, in Richtung auf die angrenzenden PV-Zellen (2) zu leiten.

14. Photovoltaikmodul nach einem der Ansprüche 1 bis 13, wobei das rückseitige leitfähige Substrat (10) eine oder mehrere leitfähige Folien umfasst.

15. Photovoltaikmodul nach einem der Ansprüche 1 bis 14, wobei der Schaltkreis serielle Gruppen von PV-Zellen (2) und Bypass-Dioden (5), gestaffelte Gruppen von PV-Zellen (2) und Bypass-Dioden (5) und/oder mehrstufige Gruppen von PV-Zellen (2) und Bypass-Dioden (5) umfasst.

## Revendications

1. Module photovoltaïque comprenant
un substrat conducteur de face arrière (10),
une pluralité de cellules photovoltaïques (PV) (2) ayant des contacts arrière et étant agencée dans une matrice sur une surface supérieure du substrat conducteur de face arrière (10),
dans lequel un circuit de cellules PV (2) connectées en série et/ou en parallèle est formé par des connexions (8) entre les contacts arrière et le substrat conducteur de face arrière (10), et
une pluralité de diodes de dérivation (5) ayant des contacts arrière (6a, 6b) en contact électrique avec le circuit de cellules PV connectées en série et/ou en parallèle (2), dans lequel chaque diode de dérivation (5) est une diode à base de tranche et est connectée en parallèle à une ou plusieurs cellules photovoltaïques de la pluralité de cellules photovoltaïques (2),
**caractérisé en ce que**
les diodes de dérivation (5) sont positionnées sur des parties vides (4) de la surface supérieure du substrat conducteur de face arrière (10), les parties vides (4) étant situées entre des coins de cellules adjacentes de la pluralité de cellules PV (2).

2. Module photovoltaïque selon la revendication 1, dans lequel les diodes à base de tranche sont obtenues à partir d'une tranche multicristalline.

3. Module photovoltaïque selon la revendication 1 ou 2, dans lequel chaque diode de dérivation de la pluralité de diodes de dérivation (5) comprend une configuration de contact arrière à transfert de métallisation (MWT), à transfert d'émetteur (EWT) ou interdigitée.

4. Module photovoltaïque selon l'une quelconque des revendications 1 à 3, dans lequel chaque cellule PV de la pluralité de cellules PV (2) a une forme rectangulaire avec au moins un coin oblique.

5. Module photovoltaïque selon l'une quelconque des revendications 1 à 3, dans lequel chaque cellule PV de la pluralité de cellules PV (2) est rectangulaire avec au moins un coin oblique, et la pluralité de cellules PV (2) est agencée en groupes de deux ou quatre avec les un ou plusieurs coins obliques respectifs se faisant mutuellement face et formant les parties vides (4) de la surface supérieure du substrat conducteur de face arrière (10) pour les diodes de dérivation (5).

6. Module photovoltaïque selon l'une quelconque des revendications 1 à 5, dans lequel les diodes de dérivation (5) ont une forme triangulaire.

7. Module photovoltaïque selon l'une quelconque des revendications 1 à 6, dans lequel une diode de dérivation (5) est présente pour chaque cellule PV de la pluralité de cellules PV (2).

8. Module photovoltaïque selon l'une quelconque des revendications 1 à 7, dans lequel chaque diode de dérivation de la pluralité de diodes de dérivation (5) est positionnée à un bord d'une cellule PV (2) associée.

9. Module photovoltaïque selon l'une quelconque des revendications 1 à 8, dans lequel la cellule PV (2) comprend un sous-module avec une pluralité de cellules PV de plus petite taille (2).

10. Module photovoltaïque selon l'une quelconque des revendications 1 à 9, dans lequel chaque cellule PV de la pluralité de cellules PV (2) est fabriquée à partir de tranches d'un matériau semi-conducteur, par exemple de matériau de type Cz monocristallin.

11. Module photovoltaïque selon l'une quelconque des revendications 1 à 10, dans lequel chaque diode de dérivation de la pluralité de diodes de dérivation (5) comprend une surface avant (22) ayant une texture et une couleur similaire à une surface avant des cellules PV (2).

12. Module photovoltaïque selon l'une quelconque des revendications 1 à 11, dans lequel chaque diode de dérivation de la pluralité de diodes de dérivation (5) comprend une surface avant opaque (22).

13. Module photovoltaïque selon l'une quelconque des revendications 1 à 12, dans lequel chaque diode de dérivation de la pluralité de diodes de dérivation (5) comprend une couche supérieure de diversion de lumière agencée pour diriger la lumière incidente sur la surface avant (22) de la diode de dérivation (5) vers les cellules PV (2) adjacentes.

14. Module photovoltaïque selon l'une quelconque des revendications 1 à 13, dans lequel le substrat conducteur de face arrière (10) comprend une ou plusieurs feuilles conductrices.

15. Module photovoltaïque selon l'une quelconque des revendications 1 à 14, dans lequel le circuit comprend des groupes de cellules PV (2) et de diodes de dérivation (5) en série, des groupes décalés de cellules PV (2) et de diodes de dérivation (5), et/ou des groupes multiniveaux de cellules PV (2) et de diodes de dérivation (5).
